(19) Europäisches Patentamt / European Patent Office / Office européen des brevets

(11) **EP 3 081 953 B1**

(12) **EUROPÄISCHE PATENTSCHRIFT**

(45) Veröffentlichungstag und Bekanntmachung des Hinweises auf die Patenterteilung:
**14.09.2022 Patentblatt 2022/37**

(21) Anmeldenummer: **16165466.0**

(22) Anmeldetag: **15.04.2016**

(51) Internationale Patentklassifikation (IPC):
**G01R 33/36** (2006.01)    **G01R 33/565** (2006.01)

(52) Gemeinsame Patentklassifikation (CPC):
**G01R 33/3628; G01R 33/34092;** G01R 33/34069;
G01R 33/3635; G01R 33/422; G01R 33/5659

(54) **NMR SENDE/EMPFANGSSPULENANORDNUNG**

NMR TRANSMITTING/RECEIVING COIL ARRANGEMENT

SYSTEME DE BOBINE DE RECEPTION ET D'EMISSION RMN

(84) Benannte Vertragsstaaten:
**AL AT BE BG CH CY CZ DK EE ES FI FR GB GR HR HU IE IS IT LI LT LU LV MC MK MT NL NO PL PT RO RS SE SI SK SM TR**

(30) Priorität: **15.04.2015 DE 102015206788**

(43) Veröffentlichungstag der Anmeldung:
**19.10.2016 Patentblatt 2016/42**

(73) Patentinhaber: **Bruker Switzerland AG**
**8117 Fällanden (CH)**

(72) Erfinder: **Freytag, Nicolas**
**8122 Binz (CH)**

(74) Vertreter: **Kohler Schmid Möbus Patentanwälte Partnerschaftsgesellschaft mbB**
**Gropiusplatz 10**
**70563 Stuttgart (DE)**

(56) Entgegenhaltungen:
EP-A1- 0 193 783    US-A- 5 045 792
US-A- 5 929 639    US-A1- 2004 217 761
US-A1- 2013 221 968

**Beschreibung**

Die Erfindung betrifft eine Kernspinresonanz-Spulenanordnung mit mindestens einer ebenen oder zylinderförmigen, im Betrieb stromdurchflossenen Spule, die im Betrieb ein hochfrequentes magnetisches $B_1$-Feld am Ort einer Messprobe erzeugt, das parallel zu einer x-Achse orientiert ist, und die zum Anschluss an ein Abstimmungsnetzwerk mit mindestens zwei elektrischen Zuleitungen verbunden ist, die im Betrieb mit phasengleichen Strömen durchflossen werden und ein hochfrequentes magnetisches $B_2$-Feld in der Messprobe erzeugen, dessen Orientierung einen Winkel $\alpha$ mit der Richtung des $B_1$-Feldes einschließt, wobei unter $B_1$-Feld lediglich der Teil des hochfrequenten Magnetfeldes verstanden wird, der durch den Strom durch die Leiter und durch eventuell integrierte Kondensatoren der

Spule erzeugt wird, nicht jedoch durch die Ströme durch andere Leiter, wie z.B. die Zuleitungen zur Spule, wobei die Spule aus einem zentralen Bereich, in dem die höchsten $B_1$-Feldamplituden erzielt werden, und einem oberen und unteren Randbereich besteht, in dem das $B_1$-Feld abfällt und dessen Magnitude mit oder ohne Nulldurchgang gegen 0 strebt. Eine solche Anordnung ist bekannt aus US-A 5,045,792.

Hintergrund der Erfindung

Auch in US 2004/217761 A1 ist eine ähnliche Spulenanordnung beschrieben.

Eine weitere ähnliche Anordnung ist bekannt aus US 7,397,246 B2.

Spulenanordnungen dieser Art sind auch in US 6,175,237 B1 oder in DE 40 38 106 C2 beschrieben.

In US 7,397,246 B2 sind Mehrwindungssattelspulen und deren Zuleitungen dargestellt. US 6,812,703 B2 zeigt einen Resonator mit Zuleitungen. Ebenso sind Spulen und Resonatoren mit Zuleitungen abgebildet (dortige Figuren 8.2 8.26, 8.33, 8.34, 8.36, 8.61, 8.68, 8.76) im Kapitel 8 in "NMR Probeheads for Biophysical and Biomedical Experiments: Theoretical Principles & Practical Guidelines"; Joel Mispelter, Mihaela Lupu, Andre Briguet ; Imperial College Press, 2006; ISBN 1860946372.

In der hochauflösenden NMR von Flüssigkeiten werden Messköpfe verwendet in denen in der Regel Spulenanordnungen eingesetzt werden, die aus mindestens einer Sattelspule, mindestens einem Birdcage-, Alderman-Grant- oder vergleichbarem Resonatoren bestehen. Insbesondere im Bereich von Messköpfen für Mikro-Samples aber auch bei Messköpfen die Hochtemperatursupraleitendes Material für die Sende- und/oder Empfangsspulenanordnungen einsetzen werden auch plane Spulen bzw. Resonatoren verwendet. Im Folgenden soll zwischen Spulen und Resonatoren nicht explizit unterschieden werden, d.h. wenn von Spulen 18 die Rede ist sind Spulen und/oder Resonatoren gemeint. Auch findet keine Unterscheidung zwischen Spulen auf ebenem oder zylinderförmigem Substrat statt.

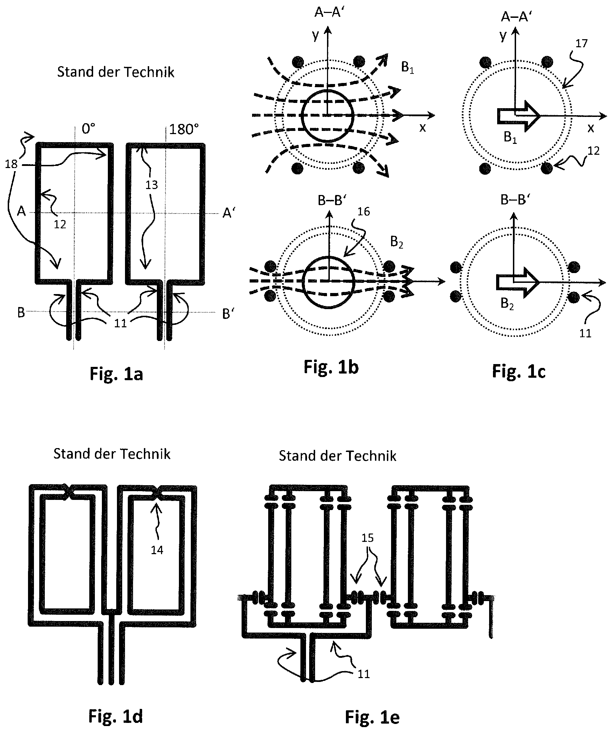

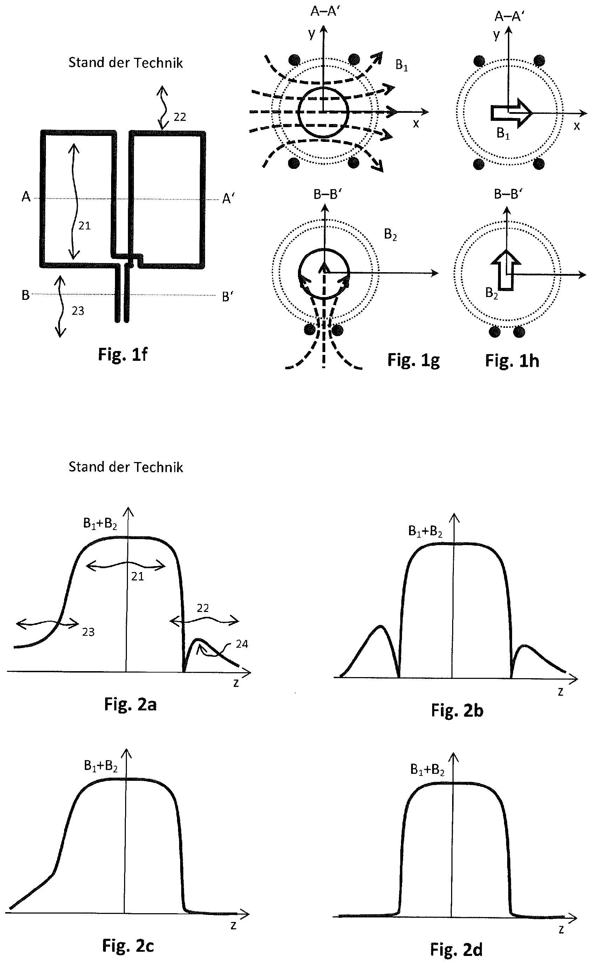

Diese Spulen 18 werden mittels Zuleitungen 11 mit einem Netzwerk verbunden, mittels dessen die Spulen auf eine oder mehrere Resonanzfrequenzen angepasst werden, die als Sende- und Empfangsfrequenzen im Betrieb des Messkopfes dienen. Die Figuren 1a, 1d, 1e und 1f zeigen beispielhaft Ein- bzw. Zwei-Windungs-Sattelspulenanordnungen, einen Birdcage-Resonator sowie eine zwei-mal-Einwindungs-Seriespulenanordnung jeweils inklusive Zuleitungen 11 in einer Abwicklungsdarstellung.

Der Schnitt der positiven Richtung der xz-Ebene mit der Abwicklung ist in Fig. 1a mit 0°, derjenige mit der negativen Richtung der xz-Ebene mit 180° gekennzeichnet. Die yx-Ebene schneidet die Spulen im Zentrum und ist als Schnittebene A-A' schematisch dargestellt. In den anderen Zeichnungen gelten die äquivalenten Positionen bezüglich des Koordinatensystems, auch wenn diese nicht explizit dargestellt oder bezeichnet werden.

Derartige Spulenanordnungen können mit zwei (Figuren 1e und 1f), mit drei (Fig. 1d) oder mit vier Zuleitungen (Fig. 1a) ausgerüstet sein und die Spulenhälften in Serie oder parallel verschaltet werden. Die Verschaltung kann innerhalb der Spule (Figuren 1d bis 1f) oder außerhalb erfolgen (Figuren 1a und 1d). Ein Birdcage kann als Hoch-, Tief- oder Bandpass-Birdcage ausgeführt werden, die spezielle Ausführungsvariante in Fig. 1e dient lediglich der Illustration eines Resonators. Auch eine Sattelspule mit integrierter Kapazität zwischen den Leitern, die selbstresonant betrieben wird stellt einen Resonator dar. Resonatoren werden in der Regel mit lediglich zwei Zuleitungen am Netzwerk kontaktiert, da der Strom im Betrieb weitestgehend innerhalb des Resonators begrenzt ist und keine Vorzüge durch die Verwendung einer Vielzahl von Zuleitungen zu erwarten ist. Es ist auch insbesondere für Resonatoren üblich diese induktiv anzukoppeln, wobei die Kopplungsinduktivität Teil des Resonators wird. Die Zuleitungen zu einer solchen Kopplungsspule sollen hier als Spulenzuleitungen verstanden werden.

Die verwendeten Sattelspulen sowie Resonatoren sind normalerweise zylinderförmig aufgebaut und bestehen aus "Stangenelementen" 12, d.h. Elemente, die weitestgehend parallel zur Zylinderachse orientiert sind und "Ringelementen" 13, d.h. Elemente, die weitestgehend orthogonal zur Zylinderachse orientiert sind.

Auch die Messproben 16 sind in der Regel zylinderförmig oder ellipsoidal und weisen eine Zylinder- bzw. eine Hauptachse auf. Die Achsen der Spulen und Messproben fallen mit der z-Achse eines Koordinatensystems zusammen. Die Feldrichtung des statischen Magnetfeldes ist in der Regel parallel, orthogonal oder unter dem sog. magischen Winkel von ca. 54° zu dieser Achse orientiert.

In den häufigsten Fällen sind sowohl die Messproben 16 als auch die Spulen zumindest weitestgehend kreiszylinderförmig ausgeführt, wobei die Leiterelemente der Spulen (sowohl Stangenelemente 12 als auch Ringelemente 13) auf ein oder zwei Radien zu liegen kommen. Lediglich eventuell enthaltene Kreuzungspunkte 14 verlassen diese Radien. Die Spulen können auch Trägerelemente 18 aus dielektrischem Material enthalten. Verbindungen zwischen den Radien können durch kapazitiv wirkende Elemente (verteilte Kapazitäten durch integrierte Plattenkondensatoren, z.B. gebildet durch überlappende Leiterelemente und das dielektrische Trägermaterial 18 oder lokalisierte Kapazitäten realisiert durch diskrete Elemente, d.h. eingelötete Kondensatoren) oder galvanische Verbindungen erreicht werden.

Auch bei ebenen (planen oder biplanen) Spulen können Stangenelemente und Ringelemente unterschieden werden, dabei soll immer davon ausgegangen werden, dass die Stangenelemente weitestgehend parallel zur z-Achse orientiert sind und die Ringelemente weitestgehend orthogonal zu dieser.

Die Zuleitungen können entweder mit den Ringelementen (Fig. 1a) oder mit den Stangenelementen (Fig. 1e) verbunden sein. Es ist auch möglich eine Zuleitung mit einem Ringelement und eine zweite mit einem Stangenelement zu verbinden (Figuren 1d und 1f).

Die Spulen erzeugen im Betrieb ein hochfrequentes (HF) magnetisches (B) Feld, das hier als $B_1$-Feld bezeichnet wird. Unter $B_1$-Feld soll lediglich der Teil des hochfrequenten Magnetfeldes verstanden werden, der durch den Strom durch die Leiter (und durch eventuell integrierte Kondensatoren) einer Spule erzeugt wird, nicht jedoch durch die Ströme durch andere Leiter, wie z.B. die Zuleitungen zur Spule. Die Frequenz wird dabei so abgestimmt, dass sie der Resonanzfrequenz der zu detektierenden Kern-Spezies im gegebenen statischen Magnetfeld $B_0$ weitestgehend entspricht.

Dieses $B_1$-Feld kann entweder linear oder zirkular polarisiert sein, wobei bei zirkular polarisiertem Feld mindestens zwei Zuleitungspaare zur Anregung vonnöten sind, die in der Regel orthogonal zueinander ausgeführt sind und zwei auf derselben Frequenz abgestimmte Moden der Spule anregen. Die Zuleitungspaare können so gebildet werden, dass sie eine gemeinsame Zuleitung aufweisen, also aus lediglich drei Zuleitungen bestehen.

Jeder dieser Moden kann durch ein linear polarisiertes Feld beschrieben werden. Dieses linear polarisierte Feld hat eine Präferenzrichtung und zumindest weitestgehend eine Symmetrieebene zu der das Feld im Messvolumen parallel steht. Für eine linear polarisierte Spule soll diese Ebene mit der xz-Ebene übereinstimmen.

Für zirkular polarisierte Spulen soll die durch das $B_1$-Feld des ersten linear polarisierten Modes definierte Ebene mit der xz-Ebene übereinstimmen. In der Regel wird dann die durch den zweiten Mode definierte Ebene mit der yz-Ebene übereinstimmen. Alle Zuleitungen, die zur Anregung eines linear polarisierten Modes bzw. einer Spule mit lediglich einem Mode verwendet werden weisen phasengleiche Ströme auf. Die Ströme in Zuleitungen für einen entarteten zweiten linear polarisierten Modes einer in Quadratur betriebenen Spule weisen eine Phasenverschiebung von ungefähr +90° oder -90° zur Anregung des ersten linear polarisierten Modes auf. Eine in Quadratur betriebene Spule kann als Kombination von zwei linear betriebenen Spulen betrachtet werden, wobei beide Spulen gemeinsame Leiterelemente aufweisen. In der Folge werden daher nur linear polarisierte Spulen behandelt und wir betrachten folglich auch lediglich Zuleitungen zu einer Spule bzw. einem Resonator, die alle dieselbe Phase aufweisen. Zuleitungen zu verschiedenen Spulen (respektive also auch verschiedenen Moden ein und derselben Spule) werden explizit nicht betrachtet. Ströme, die in einer Zuleitung "nach oben" und in einer zweiten "nach unten" fließen sollen als phasengleich betrachtet werden.

Eine Spule besteht aus einem zentralen Bereich 21, in dem die höchsten $B_1$-Feldamplituden erzielt werden und einem oberen 22 und unteren 23 Randbereich, in dem das $B_1$-Feld abfällt und dessen Magnitude mit oder ohne Nulldurchgang gegen 0 strebt. Ist ein Nulldurchgang vorhanden, weisen die Spulen ein lokales Maximum 24 im Randbereich auf. Als unterer Bereich soll derjenige verstanden werden, in dessen Nähe die Zuleitungen montiert sind, bzw. in dessen Richtung die Zuleitungen geführt werden, unabhängig davon wie diese Richtung effektiv im Raum orientiert ist. Der obere Bereich ist derjenige Randbereich ohne Zuleitungen. Es existieren auch Spulen bei denen Zuleitungen auf beiden Seiten montiert sind. In diesem Falle hat diese Spule lediglich untere Bereiche und weist keinen oberen Randbereich auf. Die positive Richtung der z-Achse kann in letzterem Falle beliebig gewählt werden, ansonsten soll die positive z-Richtung in Richtung der oberen Randbereiche zeigen.

Im bekannten Stand der Technik werden die Zuleitungen normalerweise als Paare von jeweils zwei Zuleitungen am selben Ende der Spule montiert und dann weitestgehend parallel zur Zylinderachse nach unten geführt. Die Zuleitungspaare sind üblicherweise entweder so ausgeführt, dass sie symmetrisch zur xz-Ebene (Figuren 1a, 1e) oder orthogonal zu dieser (Figuren 1d, 1f), i.e. symmetrisch zur yz-Ebene stehen. Letzteres ist insbesondere bei Serieverschaltung der beiden Spulenhälften üblich.

Bei einer ungeraden Anzahl von Zuleitungen werden in der Regel zwei Zuleitungen außerhalb der Spule miteinander verschaltet, so dass im Betrieb z.B. der Betrag des Stromes in einer Zuleitung gleich der Summe der Ströme durch zwei Zuleitungen ist. Wird die Verschaltung kapazitiv und nicht galvanisch durchgeführt, können statische Moden der Spule unterdrückt werden. Wird die Verschaltung mittels Sperrfilter realisiert, können Kopplungen zu weiteren Spulen reduziert werden. Da zwei Zuleitungen effektiv wie eine einzelne wirken, sollen auch dergestalt verschaltete Zuleitungen als "Zuleitungspaar" verstanden werden.

Die Zuleitungen können galvanisch mit der Spule verbunden werden (Figuren. 1a, 1d, 1f). Auch eine kapazitive Einkopplung 15 (Fig. 1e) oder eine induktive Einkopplung ist im Stand der Technik üblich, insbesondere für den Fall von Resonatoren.

Beim Wechsel der Messprobe müssen Frequenzabstimmung ("Tuning") und Impedanz Anpassung ("Matching") der Messprobe angepasst werden, da die Messsubstanzen und Lösungsmittel in der Regel unterschiedliche dielektrische Konstanten und Verluste aufweisen, die die Resonanzfrequenz und Impedanz der Spule verändern. Diese Veränderung muss durch das Netzwerk korrigiert werden.

Die einfachste Variante des Tunings ist ein variabler Kondensator, der über ein Zuleitungspaar mit einer Induktivität parallel geschaltet wird. Dabei ist es am effizientesten, wenn diese Induktivität den größten Teil der Induktivität der Spule darstellt. Die einfachste Variante des Matchings ist ebenfalls durch einen einzelnen variablen Kondensator realisiert, der entweder einen Eingangsport mit dem Netzwerk oder einen Eingangsport mit Masse verbindet und so die Portimpedanz hoch oder heruntertransformiert und an die Impedanz anpasst, die an den Spulenzuleitungen anliegt. Alternative Formen der Impedanz- und Frequenzanpassung beinhalten Induktivitäten mit variabler Kopplung, Transmissionsleitungen, Transformatoren, kapazitive Brücken aber auch Koppler wie z.B. Quadraturhybride oder Rat-race oder Transmissionsleitungen sowie deren durch diskrete Elemente erstellte Äquivalentschaltungen.

Die Wirkung unterschiedlicher Beschaltung auf die von den Spulenanordnungen bzw. den Zuleitungen erzeugten magnetischen Felder ist weitestgehend unabhängig von der konkreten Ausführungsform. Die Zielsetzung bei allen Varianten ist üblicherweise in einem Paar von Zuleitungen gegengleiche Ströme und Potentiale zu erzeugen und somit sind die Impedanzen bei der oder den Messfrequenzen an den Zuleitungen bei verschiedenen Netzwerkvarianten weitestgehend identisch oder zumindest sehr ähnlich.

Bei Mehrkernschaltungen ist es nicht trivial für alle Resonanzfrequenzen die Forderung gegengleicher Potentiale an den Zuleitungen zu erreichen. Hier können daher Diskrepanzen zwischen verschiedenen Netzwerken auftreten. Solange die Resonanzfrequenzen jedoch deutlich unterhalb der Eigenresonanzen der verwendeten Spulen liegen kann davon ausgegangen werden, dass die Beträge der Ströme durch die Zuleitungen weitestgehend identisch sind. Sind die Eigenresonanzen nahe oder sogar unterhalb der Betriebsfrequenz muss darauf geachtet werden die Potentiale so einzustellen, dass die Spule möglichst effizient betrieben werden kann, indem die Nullstellen des Stromes im Betrieb möglichst so in der Spule oder den Zuleitungen positioniert werden dass eine möglichst geringe Reduktion des $B_1$-Feldes in der Messprobe resultiert.

Durch das Verändern der Tuning- und Matching-Abstimmelemente (in der Regel Kondensatoren oder Induktivitäten) fallen im Betrieb mit verschiedenen Messproben unterschiedliche Ströme durch die Zuleitungen an, die bei fast allen Varianten von Spulen/Resonatoren einen starken Einfluss auf die Flanken des magnetischen Feldprofils der Spulen im Messvolumen haben. Dies gilt insbesondere für den Fall von Resonatoren oder Spulen, die nahe bei ihrer Eigenresonanz betrieben werden, so dass im Betrieb der Strom durch die Zuleitungen deutlich geringere Magnitude aufweist als der Strom in der die Spulenanordnung.

Ein Ziel beim Aufbau eines Messkopfes ist es ein möglichst rechteckförmiges hochfrequentes B-Feldprofil in der Messprobe zu generieren. Insbesondere soll vermieden werden, dass Signale aus Bereichen der Messprobe aufgefangen werden, die weit vom zentralen Bereich entfernt sind. Der Grund hierfür ist, dass die Auflösung einer NMR Messung von der erreichbaren statischen $B_0$ Magnetfeldhomogenität im Messvolumen abhängt. Diese ist umso schwieriger zu erreichen je größer das Messvolumen wird. Insbesondere problematisch ist ein "flaches" HF-Magnetfeldprofil für den Fall einer Lösungsmittelunterdrückung, da das Shimmen des statischen Feldes in der Regel dazu führt dass die Randbereiche des Detektionsvolumens ein anderes statisches Magnetfeld aufweisen als dessen zentraler Bereich. Durch den höheren Beitrag des zentralen Bereiches zum gemessenen Signal findet beim Shimmen eine Priorisierung statt, die aufgrund der begrenzten Anzahl an verfügbaren Shimfunktionen zu Abweichungen im Randbereich führen. Die zugehörigen Signale fallen in der Regel nur mit wenigen oder sogar unter einem Prozent des Gesamtsignals kaum ins Gewicht und führen zu einer Linienverbreiterung "im Fuß" der Resonanzlinie.

Durch die abweichende Resonanzfrequenz in Randbereichen der Messproben wird dort die Lösungsmittelunterdrückung jedoch ineffizient. Da das Lösungsmittelsignal um Größenordnungen größer sein kann als das Signal der Messsubstanz, weisen die gemessenen Spektren Artefakte oder breite Bereiche schlecht unterdrückten Lösungsmittelsignals auf, wenn aus Randbereichen zu starkes (und frequenzverschobenes) Signal aufgepickt wird.

Fig. 2a zeigt ein typisches Magnitudenprofil des HF-Magnetfeldes einer Sattelspule in log-lin Skala. Am oberen Ende ist ein Nulldurchgang des Feldes zu erkennen, der im unteren Bereich durch das von den Strömen durch die Zuleitungen erzeugte HF-Magnetfeld maskiert wird. Dieser Nulldurchgang entsteht dadurch, dass die Feldlinien des HF-Magnetfeldes in sich geschlossen sind. Alle Feldlinien, die durch das Innere der Spule, insbesondere auch durch die Messprobe gehen, sind im Raum geschlossen. Ein Teil dieser Feldlinien ist in Ebenen parallel zur xy-Ebene, andere hingegen sind in der xz Ebene beziehungsweise beliebig im Raum geschlossen. Somit entsteht ein Bereich in der Messprobe mit "umgekehrter" Feldrichtung, wobei die Amplitude in der Regel ungefähr eine Größenordnung geringer ausfällt als das Feld im Zentrum der Spule. Durch geschickte Positionierung von HF-Abschirmungen kann im oberen Bereich eine Begrenzung des HF-Magnetfeldes auf einen engen Bereich erreicht werden, im unteren Bereich jedoch ist dies nicht im selben Umfang möglich, da lediglich eine exponentielle Dämpfung der verbleibenden Felder in der HF-Abschirmung möglich ist (siehe Fig. 2c).

Im Stand der Technik können die Abschirmungen im unteren Bereich entweder direkt auf Höhe der untersten Ringelemente oder unterhalb derselben positioniert werden. Da kein Nulldurchgang des B-Feldes vorliegt kann die Flankensteilheit nicht höher werden als durch die Dämpfung in der HF-Abschirmung.

Der Unterschied zwischen oberem und unterem Bereich wird dadurch ausgelöst, dass die Leiter der Zuleitungen zueinander beabstandet sind. Dieser Abstand kann entlang des Umfangs (angulär) aber auch radial erfolgen. Dadurch wird zwischen den Zuleitungen ein $B_2$-Feld erzeugt, dessen Orientierung einen Winkel $\alpha$ mit $-90° \leq \alpha \leq 90°$ in Bezug auf das $B_1$-Feld der Spule im zentralen Bereich aufweist.

Unter $B_2$-Feld soll äquivalent zum $B_1$-Feld lediglich der Teil des hochfrequenten Magnetfeldes verstanden werden, der durch Ströme durch die Zuleitungen zu einer Spule entstehen. Um dieses Feld zu minimieren werden im Stand der Technik die Zuleitungen so eng wie möglich zusammen geführt und falls möglich zunächst radial nach außen und erst dann parallel nach unten geführt.

Da im Betrieb zwischen den Zuleitungen eine hohe elektrische Potentialdifferenz auftritt sind dem Annähern der Zuleitungen mit unterschiedlichen Potentialen (und entgegengesetzten Strömen) Grenzen gesetzt. Werden sie zu stark angenähert, sinkt die Spannungsfestigkeit der Spule und somit auch die maximal erreichbare $B_1$-Feld-Amplitude im Sendebetrieb. Darüber hinaus steigt die Kapazität zwischen den Zuleitungen, was insbesondere bei Spulen und Resonatoren für Protonen oder Fluordetektion oft unerwünscht ist.

In Fig. 1b sind schematisch die $B_1$- und $B_2$-Felder für die in Fig. 1a definierten Schnittebenen A-A' und B-B' dargestellt. A-A' ist eine Schnittebene durch den zentralen Bereich der Spule, in dem die $B_1$-Feldamplitude mindestens 50 % der maximalen $B_1$-Feldamplitude in der Messprobe erreicht. Die in der Fig. 1a eingezeichnete Ebene A-A' ist koinzident mit der xy-Ebene. Die Ebene B-B' ist eine Ebene, die die Zuleitungen schneidet und entlang der z-Achse unterhalb der am tiefsten liegenden Leiterelemente der Spule, insbesondere in einem Bereich in dem das $B_1$-Feld der Spule die Richtung gekehrt hat, platziert ist.

Die Feldlinien des $B_1$-Feldes sind innerhalb der hier kreiszylinderförmigen Messprobe 16 definitionsgemäß weitestgehend parallel zur x-Achse orientiert (Fig. 1b, oben). Die Orientierung des $B_1$-Feldes ist schematisch in der oberen Abbildung in Fig. 1c als großer Pfeil angegeben und bildet mit der x-Achse einen Winkel von 0°. Die Feldlinien des $B_1$-Feldes sind in sich geschlossen, so dass die Orientierung des $B_1$-Feldes in der B-B'-Ebene mit der x-Achse einen Winkel von 180° aufweist (nicht dargestellt).

Die Feldlinien des $B_2$-Feldes sind für die Ausführungsform der Spule gemäß Fig. 1a zumindest im Mittel über den Schnitt B-B' durch die Messprobe ebenfalls parallel zur x-Achse ausgerichtet, wenn sie auch deutlich weniger homogen und von geringerer Amplitude als das $B_1$-Feld im zentralen Bereich der Spule/Messprobe ist. Im unteren Teil der Fig. 1c wird das $B_2$-Feld ebenfalls schematisch durch einen Pfeil dargestellt, dessen Orientierung einen Winkel von 0° zur x-Achse aufweist.

Ein weiteres Beispiel ist in den Figuren 1f bis 1h dargestellt. Für Zuleitungen, die in Richtung der y-Achse montiert werden entsteht in der Schnittebene B-B' ein $B_2$-Feld, das einen Winkel von 90° (bei alternativen Ausführungsformen auch -90°) zur x-Achse aufweist. Für den Fall inhomogener Felder soll die mittlere Richtung des $B_2$-Feldes über den Schnitt der Messprobe in der B-B' Ebene ausschlaggebend sein.

Aufgabe der Erfindung

Der vorliegenden Erfindung liegt die Aufgabe zugrunde, eine Kernspinresonanz-Spulenanordnung der eingangs definierten Art mit besonders einfachen technischen Mitteln so zu modifizieren, dass damit ein möglichst rechteckförmiges, beidseitig besonders steiles hochfrequentes B-Feldprofil erzeugt werden kann, vorzugsweise für die hochauflösende NMR-Spektroskopie, insbesondere von Flüssigkeiten.

Kurze Beschreibung der Erfindung

Diese Aufgabe wird auf überraschend einfache wie wirkungsvolle Art und Weise sowie mit ohne Weiteres zur Verfügung stehenden technischen Mitteln mit einer generischen Spulenanordnung der eingangs definierten Art dadurch gelöst, dass der Winkel $\alpha$ derart gewählt wird, dass gilt: $\alpha = 180° \pm \Delta\alpha$, wobei $\Delta\alpha < 90°$, wobei entweder mindestens zwei der elektrischen Zuleitungen einen Kreuzungspunkt aufweisen oder mindestens zwei der elektrischen Zuleitungen an Ringelementen in einem unteren Bereich der Spulenanordnung elektromagnetisch angekoppelt sind, wobei diese Ringelemente einen Kreuzungspunkt aufweisen.

Bei der erfindungsgemäßen Variante mit einem Kreuzungspunkt der Zuleitungen ist die Richtung des $B_2$-Feldes unterhalb des Kreuzungspunkts in Bezug auf oberhalb invertiert. Damit ist die Richtung des $B_2$-Feldes unterhalb des Kreuzungspunktes der Richtung des $B_1$-Feldes im zentralen Bereich zumindest für kleine $\Delta\alpha$ weitestgehend entgegengerichtet. Bei der erfindungsgemäßen Alternative mit einem Kreuzungspunkt der Ringelemente wird die Inversion der Richtung des $B_2$-Feldes bereits innerhalb der Spule erreicht so dass die Flankensteilheit des hochfrequenten Magnetfeldes maximiert werden kann.

Eine so gestaltete Spulenanordnung weist an beiden Rändern Nulldurchgänge im erzeugten hochfrequenten Magnetfeldes innerhalb der Messprobe auf, wenn keine HF-Abschirmungen montiert werden. Wenn HF-Abschirmungen geschickt montiert werden, weist die so gestaltete Spulenanordnung ein nahezu rechteckförmiges Feldprofil in der Messprobe auf, wobei insbesondere Randbereiche existieren, in denen das verbleibende hochfrequente Magnetfeld nahezu null, insbesondere über eine Größenordnung kleiner als im zentralen Bereich ist.

Wirkungsweise der Erfindung und weitere Vorteile gegenüber dem Stand der Technik

Eine erfindungsgemäße Spulenanordnung erzeugt im Betrieb ein hochfrequentes magnetisches Feld in einer Messprobe, das sowohl im oberen Randbereich als auch im unteren Randbereich einen Nulldurchgang oder zumindest ein Minimum mit einer Magnitude des HF-B-Feldes erzeugt, die über eine Größenordnung kleiner ist als die Magnitude des HF-B-Feldes im zentralen Bereich. Dadurch wird es möglich HF-Abschirmungen so zu platzieren, dass das HF-B-Feld in der Messprobe sowohl im oberen als auch im unteren Randbereich steil abfällt und im restlichen Randbereich die Magnitude auf Werte begrenzt wird, die über eine Größenordnung kleiner sind als im zentralen Bereich. Eine so gestaltete Spulenanordnung erlaubt es mit geringerem Aufwand als Spulenanordnungen nach dem Stand der Technik die Linienform des Messsignals einer Messprobe durch Shimmen zu optimieren und erlaubt eine möglichste effiziente Unterdrückung von Lösungsmittelsignalen durch entsprechende NMR-Pulssequenzen.

Bevorzugte Ausführungsformen der Erfindung

Besonders bevorzugt sind Ausführungsformen der erfindungsgemäßen Kernspinresonanz-Spulenanordnung, bei welchen gilt:
$\Delta\alpha \leq 45°$, vorzugsweise $\Delta\alpha \leq 15°$. Für möglichst kleine $\Delta\alpha$ kann ein Minimum der Magnitude oder sogar ein Nulldurchgangspunkt oder Bereich des hochfrequenten Magnetfeldes in der Messprobe im unteren Randbereich der Spule erzielt werden. Dies reduziert die Signale aus den Randbereichen der Messprobe und vereinfacht Shimmen und Lösungsmittelunterdrückung.

Eine weitere Klasse von Ausführungsformen zeichnet sich dadurch aus, dass mindestens eine HF-Abschirmung vorhanden und so positioniert ist, dass die Summe der $B_1$- und $B_2$-Felder zumindest in einem Teilbereich der Messprobe weitestgehend Null ist. Damit wird ein möglichst rechteckförmiges Feldprofil des hochfrequenten Magnetfeldes erzeugt und eine möglichst einfache Konfiguration für eine effiziente Lösungsmittelunterdrückung sowie effizientes Shimmen erzielt.

Alternativ können bei einer anderen Klasse von Ausführungsformen der Erfindung mindestens vier elektrische Zuleitungen mit der Spulenanordnung verbunden sein, die mindestens zwei Paare von elektrischen Zuleitungen ausbilden, zwischen denen im Betrieb ein hochfrequentes $B_2^i$-Feld in der Messprobe erzeugt wird, wobei die Summe der $B_2^i$-Felder zumindest in einem Teilbereich der Messprobe weitestgehend Null ist. Eine derart gestaltete Spulenanordnung erzeugt ein weitestgehend oder sogar vollständig von den Strömen durch die Zuleitungen unabhängiges Feldprofil.

Bevorzugt sind Weiterbildungen dieser Klasse von Ausführungsformen, bei welchen mindestens Paare von elektrischen Zuleitungen auf gegenüberliegenden Seiten der Spulenanordnung montiert sind. Diese Ausführungsform ist technisch einfach zu realisieren und führt zu keinen Einschränkungen der Spannungsfestigkeit, da die Zuleitungen nicht enger zueinander positioniert werden müssen als für Spulenanordnungen im Stand der Technik.

Vorteilhaft sind auch Ausführungsformen der Erfindung, bei denen die Spulenanordnung mindestens zwei Spulen umfasst, die im Betrieb je ein hochfrequentes $B_1^i$-Feld erzeugen, wobei die Felder so ausgerichtet sind, dass sie einen Winkel $\beta$ zwischen sich einschließen, und wobei für den Winkel $\beta$ gilt:
$|\beta| < 10°$ oder $|\beta-180°| < 10°$. Für dergestalt gekoppelte Spulenanordnungen ist es möglich für mindestens einen der beiden gekoppelten Moden ein beidseitig steiles Feldprofil zu erzeugen. Dies ist insbesondere bei Anordnungen relevant, bei denen ein auf Protonen abgestimmter Resonator mit einer Sattelspule gekoppelt wird. Eine solche Spulenanordnung ermöglicht es eine Vielzahl von Kernen in einem Messkopf abzustimmen.

Bei bevorzugten Weiterbildungen dieser Ausführungsformen weist die Spulenanordnung mindestens eine HF-Abschirmung auf, so dass im Betrieb bei mindestens einer der Messfrequenzen die Summe der $B_1^i$ und $B_2^i$-Felder zumindest in einem Teilbereich der Messprobe weitestgehend Null ist. Diese Ausführungsform ermöglicht es eine Vielzahl von Kernen in einem Messkopf abzustimmen ohne Einbußen bei der Shimbarkeit oder Lösungsmittelunterdrückung hinnehmen zu müssen.

Diese Weiterbildungen können noch dadurch verbessert werden, dass mindestens eine der HF-Abschirmungen Öffnungen, insbesondere Schlitze aufweist. Durch diese Schlitze beziehungsweise Öffnungen kann das $B_2$-Feld in den Bereich der Messprobe eindringen und somit die Flankensteilheit des hochfrequenten Magnetfeldes der Spule erhöhen.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden, sofern hierdurch der durch die Ansprüche definierte Schutzbereich der Erfindung nicht verlassen wird. Die gezeigten und beschriebenen Ausführungsformen sind nicht als abschließende Aufzählung zu verstehen, sondern haben vielmehr beispielhaften Charakter für die Schilderung der Erfindung.

Detaillierte Beschreibung der Erfindung und Zeichnung

Die Erfindung ist in der Zeichnung dargestellt und wird anhand von Ausführungsbeispielen näher erläutert. Es zeigen:

Fig. 1a     eine Spulen-Anordnung mit Einwindungssattelspulen und vier Zuleitungen in Abwicklungsdarstellung nach dem Stand der Technik;

Fig. 1b     den schematischen Verlauf der Feldlinien des $B_1$- und des $B_2$-Feldes in den Ebenen A-A' respektive B-B' bei einer Anordnung gemäß Fig. 1a;

Fig. 1c     die Richtung des $B_1$- und des $B_2$-Feldes in den Ebenen A-A' respektive B-B' bei einer Spulenanordnung gemäß Fig. 1a;

Fig. 1d     eine Spulen-Anordnung mit zwei parallelgeschalteten Zweiwindungssattelspulen und drei Zuleitungen in Abwicklungsdarstellung nach dem Stand der Technik;

Fig. 1e     eine Birdcage-Resonator-Anordnung mit zwei Zuleitungen und kapazitiver Ankopplung in Abwicklungsdarstellung nach dem Stand der Technik;

Fig. 1f     eine Spulen-Anordnung mit zwei in Serie geschalteten Einwindungssattelspulen und zwei Zuleitungen in Abwicklungsdarstellung nach dem Stand der Technik;

Fig. 1g     den schematischen Verlauf der Feldlinien des $B_1$- und des $B_2$-Feldes in den Ebenen A-A' respektive B-B' bei einer Anordnung gemäß Fig. 1f;

Fig. 1h     die Richtung des $B_1$- und des $B_2$-Feldes in den Ebenen A-A' respektive B-B' bei einer Spulenanordnung gemäß Fig. 1f;

Fig. 2a     schematische Darstellung des Magnetfeld-Verlaufs in log-lin-Skala der Summe der $B_1$- und $B_2$-Felder bei Spulen-Anordnungen nach dem Stand der Technik;

Fig. 2b     schematische Darstellung des Magnetfeld-Verlaufs in log-lin-Skala der Summe der $B_1$- und $B_2$-Felder bei erfindungsgemäßen Spulen-Anordnungen;

Fig. 2c     schematische Darstellung des Magnetfeld-Verlaufs in log-lin-Skala der Summe der $B_1$- und $B_2$-Felder bei Spulen-Anordnungen mit optimal platzierten HF-Abschirmungen nach dem Stand der Technik;

Fig. 2d     schematische Darstellung des Magnetfeld-Verlaufs in log-lin-Skala der Summe der $B_1$- und $B_2$-Felder bei erfindungsgemäßen Spulen-Anordnungen mit optimal platzierten HF-Abschirmungen;

Fig. 3a     eine schematische Darstellung einer ersten Ausführungsform der erfindungsgemäßen Spulenanordnung mit Kreuzungspunkten in den Zuleitungen;

Fig. 3b     den schematischen Verlauf der Feldlinien des $B_1$- und des $B_2$-Feldes in den Ebenen A-A' respektive B-B' bei einer Anordnung gemäß Fig. 3a;

Fig. 3c     die Richtung des $B_1$- und des $B_2$-Feldes in den Ebenen A-A' respektive B-B' bei einer Spulenanordnung gemäß Fig. 3a;

Fig. 4a     eine schematische Darstellung einer zweiten Ausführungsform der erfindungsgemäßen Spulenanordnung mit seriell verschalteten Einwindungsspulen und zwei Zuleitungen;

Fig. 4b     den schematischen Verlauf der Feldlinien des $B_1$- und des $B_2$-Feldes in den Ebenen A-A' respektive B-B' bei einer Anordnung gemäß Fig. 4a;

Fig. 4c     die Richtung des $B_1$- und des $B_2$-Feldes in den Ebenen A-A' respektive B-B' bei einer Spulenanordnung gemäß Fig. 4a;

Fig. 5     Abwicklungsdarstellung einer dritten Ausführungsform der erfindungsgemäßen Spulenanordnung mit Kreuzungspunkten innerhalb der Spule;

Fig. 6a     eine schematische Darstellung einer vierten Ausführungsform der erfindungsgemäßen Spulenanordnung mit zwei Paaren von Zuleitungen von denen dasjenige in Richtung der x-Achse (0°) einen Kreuzungspunkt beinhaltet und das zweite in Richtung der -x-Achse (180°) ohne Kreuzungspunkt ausgeführt ist;

Fig. 6b     eine Spulenanordnung wie in Fig.6a, bei der jedoch beide Paare von Zuleitungen in Richtung der x-Achse montiert sind; und

Fig. 7     eine Spulenanordnung bestehend aus einem Resonator und einer Sattelspule, wobei die Zuleitungen des Resonators ohne Kreuzungspunkt, diejenigen der Sattelspule mit Kreuzungspunkt ausgeführt sind und die HF-Abschirmung eine Öffnung enthält.

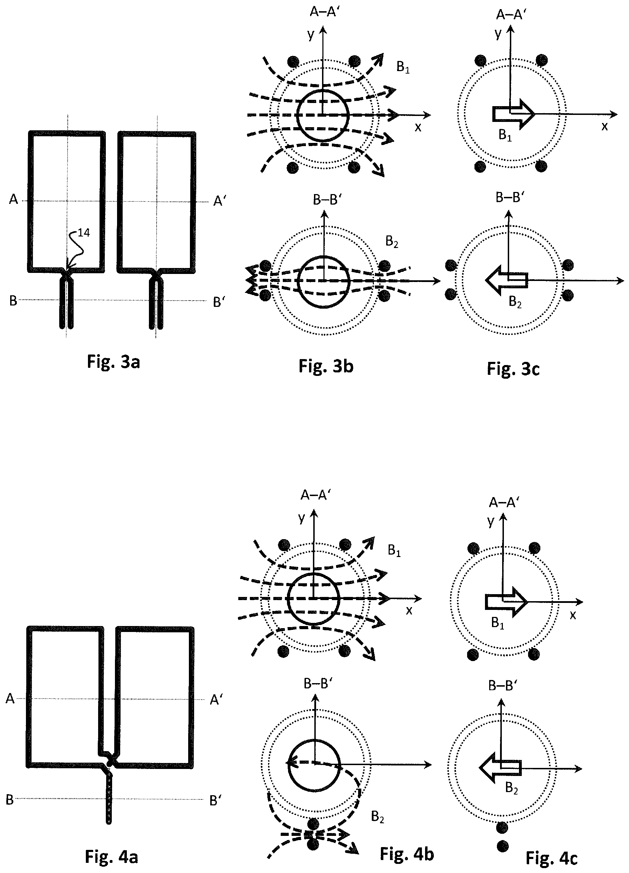

Erfindungsgemäß wird ein beidseitig steiles $B_1$-Feldprofil dadurch erzeugt, dass die Zuleitungen der Spule bzw. des Resonators mindestens einen Kreuzungspunkt in der Nähe der/des unteren Ringelemente/s aufweisen oder dass mindestens zwei der elektrischen Zuleitungen an Ringelementen in einem unteren Bereich der Spulenanordnung elektromagnetisch angekoppelt sind, wobei diese Ringelemente einen Kreuzungspunkt aufweisen. Durch diesen Kreuzungspunkt wird die Orientierung des magnetischen Feldes durch die Zuleitungen umgekehrt, so dass es entgegengesetzt zur Orientierung des hochfrequenten Magnetfeldes im zentralen Bereich der Spule ist. Fig. 3a zeigt eine erfindungsgemäße Ausführungsform einer Einwindungs-Sattelspule mit vier Zuleitungen, bei der beide Paare von Zuleitungen jeweils einen Kreuzungspunkt direkt am Ringelement aufweisen. Die Orientierung des $B_1$-Feldes weist definitionsgemäß auch in diesem Fall einen Winkel von 0° zur x-Achse auf. Im Gegensatz zu den Ausführungen gemäß Stand der Technik weist jedoch das $B_2$-Feld, wie in Fig. 3b für die Ebene B-B' dargestellt, einen Winkel von 180° zur x-Achse auf. Besonders deutlich wird dies in Fig. 3c, in der die $B_1$- und $B_2$-Felder schematisch durch Pfeile dargestellt sind und entgegengesetzte Richtung aufweisen.

Wenn das hochfrequente $B_2$-Feld, das zwischen den Zuleitungen erzeugt wird, einen Winkel $\alpha$ mit $90° < \alpha < 270°$ zum $B_1$-Feld im zentralen Bereich der Spule bzw. des Resonators aufweist kann die vektorielle Summe der $B_1$- und $B_2$-Felder einen Nulldurchgang, zumindest jedoch eine starke Reduktion der Magnitude des B-Feldes in einem Teilbereich des Randbereichs statt einer Erhöhung führen. Dies ist bei einem Winkel möglichst nahe bei 180° besonders effizient, so dass ein Winkel $\alpha$ mit $170° < \alpha < 190°$ bevorzugt ist Das resultierende hochfrequente Magnetfeldprofil ist schematisch in Fig. 2b dargestellt. Dabei ist nun die untere Flanke des Feldprofils sogar steiler als die obere, da das $B_2$-Feld im Randbereich des Profils des $B_1$-Feldes bereits von diesem abgezogen wird. Im Gegensatz dazu entsteht ein weiterer Teilbereich des Randbereiches in dem das B-Feld erhöht wird. Werden zusätzlich Abschirmungen montiert ist es für eine erfindungsgemäße Spule möglich sowohl im oberen Bereich als auch im unteren Bereich ein nahezu rechteckförmiges B-Feldprofil zu erzeugen, da der Rückfluss des B-Feldes in das Volumen außerhalb der Messprobe begrenzt werden kann.

Bevorzugte Ausführungsformen der Erfindung:

In Fig. 4a ist eine besonders vorteilhafte Ausführungsform dargestellt, bei der zwei Zuleitungen lediglich radial beabstandet sind. In der Abwicklungsdarstellung liegen die beiden Zuleitungen übereinander. Die Zuleitungen werden beide so montiert, dass beide bei ungefähr +90° oder -90° zur x-Achse positioniert sind (siehe Fig. 4b und 4c unten). Die Leiter werden so verschaltet, dass das $B_2$-Feld in der Messprobe in der Ebene B-B' einen Winkel von ungefähr 180° zur x-Achse aufweist, wie in Fig. 3b als Feldlinien und in Fig. 3c schematisch dargestellt. Diese Zuleitungsform ist für seriell verschaltete Ein- und Mehrwindungsspulen besonders vorteilhaft. Des Weiteren ist die magnetische Kopplung zu einer weiteren Spule reduziert, deren hochfrequentes magnetisches $B_3$-Feld entlang der y-Achse orientiert ist. Grundsätzlich kann jede beliebige radiale Position für die Montage der Zuleitungen verwendet werden, wenn diese dergestalt sowohl radial als auch angulär beabstandet werden, dass das resultierende $B_2$-Feld einen Winkel von idealerweise ungefähr 180° zum $B_1$-Feld im zentralen Bereich der Spule aufweist. Besonders bevorzugt sind jedoch die Ausführungsformen mit lediglich angulärer (Fig. 3a) oder radialer (Fig. 4a) Beabstandung, da es für beide Fälle besonders einfach ist eine weitere Spulenanordnung orthogonal zur ersten zu montieren und elektrisch zu entkoppeln.

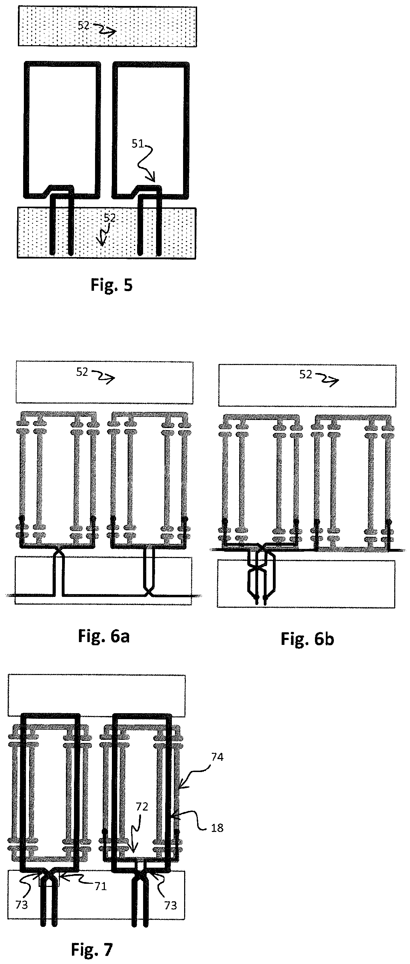

In Fig. 5 ist eine Variante der Erfindung dargestellt, bei der die Spule im oberen und unteren Bereich eine Abschirmung 52 aufweist. Durch die Kreuzungspunkte im unteren Bereich ist eine partielle Auslöschung des Feldes im unteren Randbereich sichergestellt, so dass der Abstand der Abschirmungen unten i. d. R. anders ausfällt als oben. Hierbei kommt es auf die detaillierte Ausführungsform der gekreuzten Zuleitungen und insbesondere auch der Position des Kreuzungspunktes an, ob der Abstand der Abschirmungen unten größer oder kleiner ausfällt als oben. Das zugehörige B-Feldprofil (d.h. die Summe der $B_1$- und $B_2$-Felder) ist bei idealer Positionierung der HF-Abschirmungen schematisch in Fig. 2d in log-lin Skala dargestellt.

Die Figuren 6a und 6b zeigen zwei Varianten einer Ausführungsform, die insbesondere bei der Verwendung selbstresonanter Strukturen wie z.B. Birdcage oder Alderman-Grant Resonatoren jedoch auch bei allen mittels integrierter Kondensatoren resonant abgestimmter Spulen besonders vorteilhaft ist. Dabei ist das eine Zuleitungspaar der Spule gekreuzt, ein zweites jedoch ungekreuzt ausgeführt. Die Summe der erzeugten Felder ergibt im Mittel über den relevanten unteren Bereich der Messprobe ungefähr null, so dass das B-Feldprofil ungefähr gleich dem $B_1$-Feldprofil und somit unabhängig vom Strom ist, der über die Zuleitungen geführt wird. Eine dergestalt ausgeführte Spule kann über einen sehr großen Tuningbereich hinweg dasselbe B-Feld-Profil aufweisen. Dies ist vor allem für Resonatoren von Interesse, die z.B. von $^{19}$F auf $^1$H durchstimmbar ausgelegt werden, jedoch auch für Breitband-Messköpfe die z.T. über mehrere Oktaven abstimmbar ausgeführt sind. Darüber hinaus ist bei dieser Ausführungsform die Kopplung der Zuleitungen zu einer weiteren Spulenanordnung, die innerhalb der ersten Spulenanordnung oder diese umfassend montiert ist stark reduziert, da die induktive Kopplung mit den beiden Zuleitungspaaren umgekehrtes Vorzeichen aufweist und sich daher auslöscht, solange beide Paare von Zuleitungen symmetrisch positioniert sind und die weitere Spulenanordnung ein weitestgehend symmetrisches hochfrequentes Magnetfeld erzeugt.

Bei der in Fig. 6a dargestellten Variante ist das gekreuzte Zuleitungspaar auf einer Seite der Spule (0°) befestigt, wohingegen das ungekreuzte Zuleitungspaar auf der gegenüberliegenden Seite (d.h. bei 180°) montiert wird. Zumindest auf der Achse der zylinderförmigen Spule/Resonators löschen sich die Felder der beiden Zuleitungen aus, ansonsten löschen sie sich zumindest im Mittel über einen Schnitt durch die Messprobe orthogonal zur Hauptachse weitestgehend aus. Bei alternativen Ausführungsformen können die Zuleitungen unter beliebigen Winkeln zur x-Achse montiert werden.

Im Gegensatz dazu werden bei der Variante nach Fig. 6b sowohl das ungekreuzte als auch das gekreuzte Zuleitungspaar auf derselben Seite, i.e. bei ungefähr 0° montiert. Hierdurch werden die Felder der beiden Zuleitungen lokal überlagert und löschen sich in der Messprobe fast vollständig aus. Da die beiden Leitungen eines Zuleitungspaares im Betrieb eine große Potentialdifferenz aufweisen müssen die Zuleitungen mit ausreichendem Abstand geführt werden um elektrische Durchschläge zu vermeiden. Diese notwendigen Abstände begrenzen die Auslöschung der Felder in gewissem Maße.

Fig. 7 zeigt eine Ausführungsform, bei der die Spulenanordnung zwei Spulen/Resonatoren umfasst, die miteinander induktiv gekoppelt sind, indem die von beiden erzeugten $B_1^1$- und $B_1^2$-Felder in derselben (xz-) Ebene liegen. Dabei ist die erste Spule vollständig von der zweiten Spule umfasst. Wird jede der beiden Spulen auf eine Resonanzfrequenz abgestimmt, dann entstehen durch die Kopplung zwei Moden unterschiedlicher Frequenz, bei denen jeweils im Betrieb Strom in beiden Spulen fließt. Dabei ist beim tieferen Mode der Strom der beiden Spulen gleichgerichtet (die Felder addieren sich also) und beim Mode höherer Resonanzfrequenz sind fließen die Ströme in beiden Spulen entgegengerichtet (die Felder subtrahieren sich also). In der Regel wird eine innere Spule/Resonator auf einer höheren Frequenz und eine äußere Spule/Resonator auf einer tieferen Frequenz abgestimmt, da im umgekehrten Falle (oder bei Abstimmung auf dieselbe Frequenz) die gemeinsame Resonanz des Spulenpaares auf der hohen Frequenz sehr ineffizient ist. Wird eine Ein- oder Mehrwindungsspule mit einem Resonator kombiniert und die Zuleitungen der Spule gemäß Stand der Technik ungekreuzt ausgeführt, dann kann für keine der beiden Resonanzfrequenzen des Spulenpaares ein steiles $B_1 + B_2$-Profil und insbesondere keine effiziente Unterdrückung der Restfelder im Randbereich mittels Abschirmungen erreicht werden.

Dieses Problem wird überraschend einfach dadurch gelöst, dass zumindest ein Zuleitungspaar einer der Spulen des Spulenpaares gekreuzt ausgeführt wird. Dadurch wird es möglich die Summe der $B_1^i + B_2^i$-Felder für mindestens eine der beiden Resonanzfrequenzen so anzupassen, dass sie sich im Randbereich der Spule auslöschen und sowohl oben als auch unten ein steiles hochfrequentes Magnetfeldprofil erzeugen. Wird zusätzlich eine HF-Abschirmung verbaut kann für mindestens eine Frequenz ein hochfrequentes B-Feld-Profil mit weitestgehender Auslöschung der Felder im Randbereich erreicht werden. In Fig. 7 sind die Zuleitungen 72 der inneren Spule 74 ungekreuzt ausgeführt, wohingegen die Zuleitungen der diese umfassenden äußeren Spule 18 einen Kreuzungspunkt 73 enthalten.

Um eine ausreichende Magnitude der $B_2^i$-Felder durch die Zuleitungen einer oder mehrerer äußeren/r Spule/n im Bereich der Messprobe erreichen zu können kann es notwendig sein eine oder mehrere Öffnungen oder Schlitze in der Abschirmung einzuarbeiten.

**Positionierung des Kreuzungspunktes:**

Die Kreuzungspunkte in den Paaren von Zuleitungen können so ausgeführt werden, dass die beiden Leiter sich oberhalb der unteren Ringelemente, auf den Ringelementen oder unterhalb der Ringelemente kreuzen. Bei einer bevorzugten Ausführungsform liegen die Kreuzungspunkte innerhalb des Spulenfensters. Dadurch wird eine möglichst effiziente Umkehrung der Feldrichtung des durch die Zuleitungen erzeugten $B_2$-Feldes erreicht.

Bei einer besonders einfach zu realisierenden Ausführungsform befinden sich die Kreuzungspunkte unmittelbar unterhalb der Ringelemente. Dadurch werden zusätzliche Leiterlängen minimiert und damit die Effizienz der Spulen nur geringfügig reduziert.

**Vergleich mit bekannten Spulen:**

Aus US-A 5,929,639 ist ein Spulentyp bekannt, bei dem (siehe z.B. dortige Fig. 3a) im oberen und unteren Bereich der Spule Kreuzungspunkte existieren, die die Feldrichtung umkehren. Der Unterschied zur vorliegenden Erfindung ist, dass in diesem Falle die Spule im Messvolumen kein dipolares Feld mehr erzeugen soll und die Bereiche umgekehrten Feldes gleich stark mit einer zweiten Spule koppeln sollen wie der zentrale Bereich; i.e. die das Integral des Feldes in den "Randbereichen" ist gleich groß wie das des zentralen Bereiches. Dadurch wird nicht etwa das Feldprofil steiler gestaltet sondern das Feld besitzt zwei zusätzliche Nulldurchgänge. Die Zuleitungen dieser Spulen werden wie im Stand der Technik ungekreuzt nach außen bzw. unten geführt, so dass diese Spulen effektiv drei Nulldurchgänge, nicht jedoch vier Nulldurchgänge des $B_1$-Feldes im Messvolumen aufweisen.

**Patentansprüche**

1. Kernspinresonanz-Spulenanordnung mit mindestens einer ebenen oder zylinderförmigen, im Betrieb stromdurchflossenen Spule (18), die im Betrieb ein

hochfrequentes magnetisches $B_1$-Feld am Ort einer Messprobe (16) erzeugt, das parallel zu einer x-Achse orientiert ist, und die zum Anschluss an ein Abstimmungsnetzwerk mit mindestens zwei elektrischen Zuleitungen (11) verbunden ist, die im Betrieb mit phasengleichen Strömen durchflossen werden und ein hochfrequentes magnetisches $B_2$-Feld in der Messprobe (16) erzeugen, dessen Orientierung einen Winkel $\alpha$ mit der Richtung des $B_1$-Feldes einschließt, wobei unter $B_1$-Feld lediglich der Teil des hochfrequenten Magnetfeldes verstanden wird, der durch den Strom durch die Leiter und durch eventuell integrierte Kondensatoren der Spule erzeugt wird, nicht jedoch durch die Ströme durch andere Leiter, wie z.B. die Zuleitungen zur Spule, wobei die Spule aus einem zentralen Bereich (21), in dem die höchsten $B_1$-Feldamplituden erzielt werden, und einem oberen (22) und unteren (23) Randbereich besteht, in dem das $B_1$-Feld abfällt und dessen Magnitude mit oder ohne Nulldurchgang gegen 0 strebt, **dadurch gekennzeichnet, dass** für den Winkel $\alpha$ gilt:

$$\alpha = 180° \pm \Delta\alpha,$$

wobei $\Delta\alpha < 90°$ , wobei entweder mindestens zwei der elektrischen Zuleitungen (11) einen Kreuzungspunkt (14) aufweisen oder mindestens zwei der elektrischen Zuleitungen (11) an Ringelementen (13) in einem unteren Bereich der Spulenanordnung elektromagnetisch angekoppelt sind, wobei diese Ringelemente (13) einen Kreuzungspunkt (51) aufweisen.

2. Spulenanordnung nach Anspruch 1, **dadurch gekennzeichnet, dass** $\Delta\alpha \leq 45°$, vorzugsweise $\Delta\alpha \leq 15°$.

3. Spulenanordnung nach einem der vorhergehenden Ansprüche, **dadurch gekennzeichnet, dass** mindestens eine HF-Abschirmung (52) vorhanden und so positioniert ist, dass die Summe der $B_1$- und $B_2$-Felder zumindest in einem Teilbereich der Messprobe (16) weitestgehend Null ist.

4. Spulenanordnung nach einem der vorhergehenden Ansprüche, **dadurch gekennzeichnet, dass** mindestens vier elektrische Zuleitungen (11) mit der Spulenanordnung verbunden sind, die mindestens zwei Paare von elektrischen Zuleitungen (11) ausbilden, zwischen denen im Betrieb ein hochfrequentes $B_2^i$-Feld in der Messprobe (16) erzeugt wird, wobei die Summe der $B_2^i$-Felder zumindest in einem Teilbereich der Messprobe (16) weitestgehend Null ist.

5. Spulenanordnung nach Anspruch 4, **dadurch gekennzeichnet, dass** mindestens Paare von elektrischen Zuleitungen (11) auf gegenüberliegenden Seiten der Spulenanordnung montiert sind.

6. Spulenanordnung nach einem der vorhergehenden Ansprüche, **dadurch gekennzeichnet, dass** die Spulenanordnung mindestens zwei Spulen (18, 74) umfasst, die im Betrieb je ein hochfrequentes $B_1^i$-Feld erzeugen, wobei die Felder so ausgerichtet sind, dass sie einen Winkel $\beta$ zwischen sich einschließen, und wobei für den Winkel $\beta$ gilt:

$$\left|\beta\right| < 10° \text{ oder } \left|\beta\text{-}180°\right| < 10°.$$

7. Spulenanordnung nach Anspruch 6, **dadurch gekennzeichnet, dass** die Spulenanordnung mindestens eine HF-Abschirmung (52) aufweist, so dass im Betrieb bei mindestens einer der Messfrequenzen die Summe der $B_1^i$ und $B_2^i$-Felder zumindest in einem Teilbereich der Messprobe (16) weitestgehend Null ist.

8. Spulenanordnung nach Anspruch 7, **dadurch gekennzeichnet, dass** mindestens eine der HF-Abschirmungen (52) Öffnungen (71), insbesondere Schlitze aufweist.

**Claims**

1. A nuclear magnetic resonance coil configuration having at least one flat or cylindrical coil (18), through which current flows in operation, which coil generates in operation a high-frequency magnetic $B_1$ field at the location of a sample (16) which is oriented parallel to an x-axis, and which for the purpose of connection to a tuning network is connected to at least two electrical feed lines (11), through which in-phase currents flow in operation, and which generate a high-frequency magnetic $B_2$ field in the sample (16), the orientation of which encloses an angle $\alpha$ with the direction of the $B_1$ field,

    wherein $B_1$ field merely means that part of the high-frequency magnetic field, which is generated by the current through the conductors and through possibly integrated capacitors of the coil, but not by the currents through other conductors such as e.g. the feed lines to the coil, wherein the coil consists of a central area (21) in which the highest $B_1$ field amplitudes are achieved, and an upper (22) and a lower (23) edge region in which the $B_1$ field drops and its magnitude approaches 0 with or without zero crossing,

    **characterized in that** the following applies for the angle $\alpha$:

$$\alpha = 180° \pm \Delta\alpha,$$

where $\Delta\alpha < 90°$, wherein either at least two of the electrical feed lines (11) have a crossing point (14) or at least two of the electrical feed lines (11) are electromagnetically coupled to ring elements (13) in a bottom region of the coil configuration, wherein these ring elements (13) have a crossing point (51).

2. Coil configuration according to claim 1, **characterized in that** $\Delta\alpha \leq 45°$, preferably $\Delta\alpha \leq 15°$.

3. Coil configuration according to one of the preceding claims, **characterized in that** at least one HF screen (52) is provided and is positioned such that the sum of the $B_1$ and $B_2$ fields is largely zero at least in a sub-region of the sample (16).

4. Coil configuration according to one of the preceding claims, **characterized in that** at least four electrical feed lines (11), which form at least two pairs of electrical feed lines (11), between which a high-frequency $B_2^i$ field is generated in the sample (16) in operation, are connected to the coil configuration, wherein the sum of the $B_2^i$ fields is largely zero at least in a sub-region of the sample (16).

5. Coil configuration according to claim 4, **characterized in that** at least pairs of electrical feed lines (11) are fitted on opposite sides of the coil configuration.

6. Coil configuration according to one of the preceding claims, **characterized in that** the coil configuration comprises at least two coils (18, 74) which each generate a high-frequency $B_1^i$ field in operation, wherein the fields are aligned such that they enclose an angle $\beta$ between them and wherein the following applies for the angle $\beta$:

$$|\beta| < 10° \text{ or } |\beta - 180°| < 10°.$$

7. Coil configuration according to claim 6, **characterized in that** the coil configuration has at least one HF screen (52) so that in operation at at least one of the measuring frequencies, the sum of the $B_1^i$ and $B_2^i$ fields is largely zero at least in a sub-region of the sample (16).

8. Coil configuration according to claim 7, **characterized in that** at least one of the HF screens (52) has openings (71), in particular slots.

**Revendications**

1. Arrangement de bobine de résonance magnétique nucléaire comprenant au moins une bobine (18) plane ou de forme cylindrique, traversée par un courant en fonctionnement, laquelle génère en fonctionnement un champ $B_1$ magnétique à haute fréquence à l'endroit d'une sonde de mesure (16), qui est orientée parallèlement à un axe x, et qui, en vue du raccordement à un réseau d'accord, est reliée à au moins deux lignes d'arrivée (11) électriques qui, en fonctionnement, sont traversées par des courants de même phase et génèrent un champ $B_2$ magnétique à haute fréquence dans la sonde de mesure (16), dont l'orientation forme un angle $\alpha$ avec la direction du champ $B_1$, le champ $B_1$ désignant seulement la partie du champ magnétique à haute fréquence qui est générée par le courant à travers les conducteurs et à travers les condensateurs éventuellement intégrés, et toutefois non pas par les courants à travers d'autres conducteurs, par exemple les lignes d'arrivée vers la bobine, la bobine se composant d'une zone centrale (21), dans laquelle sont obtenues les amplitudes de champ $B_1$ les plus élevées, et d'une zone de bordure supérieure (22) et inférieure (23), dans laquelle le champ $B_1$ chute et dont l'amplitude tend vers 0 avec ou sans passage par zéro, **caractérisé en ce que** la relation suivante est vérifiée pour l'angle $\alpha$ :

$$\alpha = 180° +/-\Delta\alpha,$$

avec $\Delta\alpha < 90°$ soit au moins deux des lignes d'arrivée (11) électriques possédant un point d'intersection (14), soit au moins deux des lignes d'arrivée (11) électriques étant accouplées à des éléments annulaires (13) dans une zone inférieure de l'arrangement de bobine, les éléments annulaires (13) possédant un point d'intersection (51).

2. Arrangement de bobine selon la revendication 1, **caractérisé en ce que** $\Delta\alpha \leq 45°$, de préférence $\Delta\alpha \leq 15°$.

3. Arrangement de bobine selon l'une des revendications précédentes, **caractérisé en ce qu'**au moins un blindage HF (52) est présent et positionné de telle sorte que la somme des champs $B_1$ et $B_2$ est en grande partie nulle au moins dans une zone partielle de la sonde de mesure (16).

4. Arrangement de bobine selon l'une des revendications précédentes, **caractérisé en ce qu'**au moins quatre lignes d'arrivée (11) électriques sont reliées à l'arrangement de bobine, lesquelles forment au moins deux paires de lignes d'arrivée (11) électriques entre lesquelles un champ $B_2^i$ à haute fréquen-

ce est formé en fonctionnement dans la zone de mesure (16), la somme des champs $B_2^i$ étant en grande partie nulle au moins dans une zone partielle de la sonde de mesure (16).

5. Arrangement de bobine selon la revendication 4, **caractérisé en ce qu'**au moins des paires de lignes d'arrivée (11) électriques sont montées sur des côtés opposés de l'arrangement de bobine.

6. Arrangement de bobine selon l'une des revendications précédentes, **caractérisé en ce que** l'arrangement de bobine comporte au moins deux bobines (18, 74), qui génèrent un champ $B_1^i$ à haute fréquence en fonctionnement, les champs étant orientés de telle sorte qu'ils forment entre eux un angle β, et la relation suivante étant vérifiée pour l'angle β:

$$|\text{ß}| < 10° \text{ ou } |\text{ß}-180°| < 10°.$$

7. Arrangement de bobine selon la revendication 6, **caractérisé en ce que** l'arrangement de bobine possède au moins un blindage HF (52), de sorte qu'en fonctionnement à au moins l'une des fréquences de mesure, la somme des champs $B_1^i$ et $B_2^i$ est en grande partie nulle au moins dans une zone partielle de la sonde de mesure (16).

8. Arrangement de bobine selon la revendication 7, **caractérisé en ce qu'**au moins l'un des blindages HF (52) possède des ouvertures (71), notamment des fentes.

Stand der Technik

0°    180°

18    13

A    12    A'

B    11    B'

**Fig. 1a**

A–A'
y    B₁
x
17
B₁
12

**Fig. 1b**    **Fig. 1c**

B–B'    16
B₂

B–B'
B₂
11

Stand der Technik

14

**Fig. 1d**

Stand der Technik

15

11

**Fig. 1e**

Stand der Technik

**Fig. 1f**

A–A'

$B_1$

**Fig. 1g**

A–A'

$B_1$

B–B'

$B_2$

B–B'

$B_2$

**Fig. 1h**

Stand der Technik

$B_1+B_2$

21

22

23

24

z

**Fig. 2a**

$B_1+B_2$

z

**Fig. 2b**

$B_1+B_2$

z

**Fig. 2c**

$B_1+B_2$

z

**Fig. 2d**

Fig. 3a

Fig. 3b

Fig. 3c

Fig. 4a

Fig. 4b

Fig. 4c

Fig. 5

Fig. 6a

Fig. 6b

Fig. 7

**EP 3 081 953 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5045792 A
- US 2004217761 A1
- US 7397246 B2
- US 6175237 B1
- DE 4038106 C2
- US 6812703 B2
- US 5929639 A

**In der Beschreibung aufgeführte Nicht-Patentliteratur**

- **JOEL MISPELTER ; MIHAELA LUPU ; ANDRE BRIGUET.** NMR Probeheads for Biophysical and Biomedical Experiments: Theoretical Principles & Practical Guidelines. Imperial College Press, 2006